# EUROPEAN PATENT APPLICATION

(11) **EP 2 343 751 A1**
(43) Date of publication of application: **13.07.2011**
(21) Application number: 09816048.4
(22) Date of filing: 08.09.2009
(51) Int. Cl.: H01L 51/46

(54) **ORGANIC PHOTOELECTRIC CONVERSION ELEMENT**

(30) Priority: 24.09.2008 JP 2008243843
(71) Applicant: Sumitomo Chemical Company, Limited, Tokyo 104-8260 (JP)
(72) Inventor: UETANI Yasunori, Tsukuba-shi Ibaraki 305-0045 (JP)
(74) Representative: Vossius & Partner
(86) International application number: PCT/JP2009/065636
(87) International publication number: WO 2010/035632

(57) **Abstract**

An organic photoelectric conversion element comprising a pair of electrodes, at least one of the electrodes being transparent or translucent, and an organic layer disposed between the pair of electrodes, wherein the organic layer comprises a conjugated polymer compound, and one or more compounds selected from the group consisting of a low-molecular-weight aromatic compound having a group derived by removing two hydrogen atoms from the structure represented by the following formula (1) and a hydroxyl group, estrogen and a nonconjugated polymer compound having a hydroxyl group: 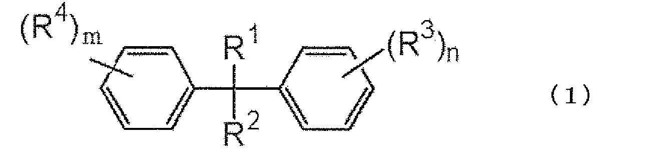 wherein R¹ and R² are the same as or different from each other, and each represent a hydrogen atom, an alkyl group or an aryl group, and a carbon atom in R¹ and a carbon atom in R² may be bonded to each other to form a ring; R³ and R⁴ are the same as or different from each other, and each represent an alkyl group or an aryl group; m and n are the same as or different from each other, and each represent an integer of 0 to 4.

## Description

### Technical Field

The present invention relates to an organic photoelectric conversion element.

### Background Art

Recently, investigations for using organic semiconductor materials as the active layers of organic photoelectric conversion elements (such as organic solar cells and optical sensors) have been actively made. In particular, by using, as organic semiconductor materials, compositions including polymer compounds, it is possible to prepare active layers with inexpensive coating methods, and hence, organic photoelectric conversion elements comprising compositions including various polymer compounds have been investigated. For example, described is an organic solar cell having an organic layer including poly(3-hexylthiophene), which is a conjugated polymer compound, and C60 PCBM, which is a fullerene derivative (Non Patent Literature 1).

### Citation List

### Non Patent Literature

Non Patent Literature 1: Advanced Functional Materials, Vol. 13 (2003) p. 85.

### Summary of Invention

### Problems to be Solved by the Invention

However, there is a problem that the above-described organic photoelectric conversion element does not necessarily have a sufficient photoelectric conversion efficiency.

Accordingly, the present invention takes as its object the provision of an organic photoelectric conversion element exhibiting a high photoelectric conversion efficiency.

### Means for Solving the Problems

The present invention provides an organic photoelectric conversion element comprising a pair of electrodes, at least one of the electrodes being transparent or translucent, and an organic layer disposed between the pair of electrodes, wherein the organic layer comprises a conjugated polymer compound and one or more compounds selected from the group consisting of a low-molecular-weight aromatic compound having a group derived by removing two hydrogen atoms from the structure represented by the following formula (1) and a hydroxyl group, estrogen and a nonconjugated polymer compound having a hydroxyl group: 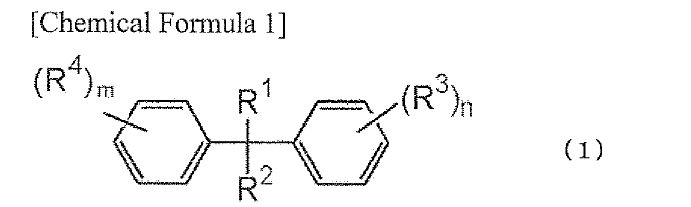 [in formula (1), R¹ and R² are the same as or different from each other, and each represent a hydrogen atom, an alkyl group or an aryl group, and a carbon atom in R¹ and a carbon atom in R² may be bonded to each other to form a ring; R³ and R⁴ are the same as or different from each other, and each represent an alkyl group or an aryl group; m and n are the same as or different from each other, and each represent an integer of 0 to 4; when there are a plurality of R³s, the R³s may be the same as or different from each other; and when there are a plurality of R⁴s, the R⁴s may be the same as or different from each other.]

In the organic photoelectric conversion element, the low-molecular-weight aromatic compound is preferably a compound having a hydroxyphenyl group, and is more preferably a compound represented by the following formula (2):

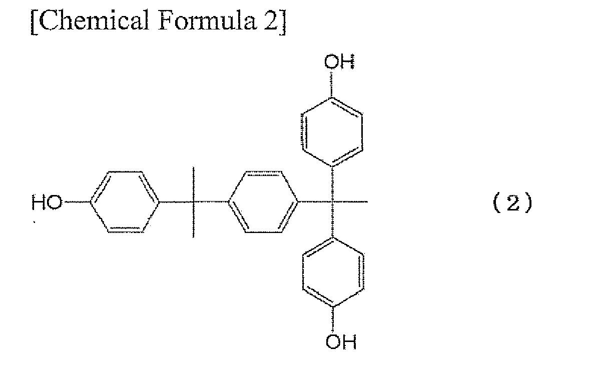

In the organic layer, the content of the one or more compounds selected from the group consisting of the low-molecular-weight aromatic compound, estrogen and the nonconjugated polymer compound having a hydroxyl group is preferably 0.1 to 10000 parts by weight in relation to 100 parts by weight of the conjugated polymer compound.

The organic photoelectric conversion element of the present invention can further comprise, in the organic layer, an electron-accepting compound, and in this case, the electron-accepting compound is preferably a fullerene derivative. Additionally, the organic photoelectric conversion element of the present invention can further comprise, in the organic layer, an electron-donating compound.

### Effects of Invention

The organic photoelectric conversion element of the present invention exhibits a high photoelectric conversion efficiency, and hence is industrially extremely useful.

### Embodiments for Carrying Out the Invention

Hereinafter, the present invention is described in detail.

The organic photoelectric conversion element of the present invention comprises a pair of electrodes, at least one of the electrodes being transparent or translucent, and an organic layer disposed between the pair of electrodes, wherein the organic layer comprises a conjugated polymer compound and one or more compounds selected from the group consisting of a low-molecular-weight aromatic compound (hereinafter, referred to as the "low-molecular-weight aromatic compound," as the case may be) having a group derived by removing two hydrogen atoms from the structure represented by the above formula (1) and a hydroxyl group, estrogen and a nonconjugated polymer compound having a hydroxyl group.

### <Low-molecular-weight Aromatic Compound>

The low-molecular-weight aromatic compound usable in the present invention has the group derived by removing two hydrogen atoms from the structure represented by the above formula (1) and a hydroxyl group. The molecular weight of the low-molecular-weight aromatic compound is preferably 94 to 1000.

In formula (1), the alkyl groups represented by R¹ or R² may be linear or branched, or a cycloalkyl group. The number of carbon atoms in each of the alkyl groups is usually about 1 to 20, and specific examples of the alkyl groups include a methyl group, an ethyl group, a n-propyl group, an i-propyl group, a n-butyl group, an i-butyl group, a t-butyl group, a s-butyl group, a 3-methylbutyl group, a n-pentyl group, a n-hexyl group, a 2-ethylhexyl group, a n-heptyl group, a n-octyl group, a n-nonyl group, a n-decyl group, a 3,7-dimethyloctyl group and a n-lauryl group. The hydrogen atom or hydrogen atoms in the alkyl groups may be substituted with a fluorine atom or fluorine atoms. Examples of the concerned substituents include a trifluoromethyl group, a pentafluoroethyl group, a perfluorobutyl group, a perfluorohexyl group and a perfluorooctyl group.

In formula (1), the aryl group represented by R¹ or R² is an atomic group in which one hydrogen atom is removed from an aromatic hydrocarbon, and examples of the atomic group include a group having a benzene ring, a group having a condensed ring, a group in which two or more independent benzene rings or condensed rings are bonded to each other directly or through the intermediary of groups such as vinylene groups. The aryl group usually has about 6 to 60 carbon atoms and preferably 6 to 48 carbon atoms. The aryl group may have a substituent or substituents. Examples of the substituent include a linear or branched alkyl group having 1 to 20 carbon atoms or a cycloalkyl group having 3 to 20 carbon atoms, or an alkoxy group containing, in the structure thereof, a linear or branched alkyl group having 1 to 20 carbon atoms or a cycloalkyl group having 3 to 20 carbon atoms, a group represented by the following formula (5) and a hydroxyl group. Specific examples of the aryl group include a phenyl group, a C₁ to C₁₂ alkoxyphenyl group (C₁ to C₁₂ means that the number of carbon atoms is 1 to 12; hereinafter, this is also the case), a C₁ to C₁₂ alkylphenyl group, a 1-naphthyl group, a 2-naphthyl group, a 1-anthracenyl group, a 2-anthracenyl group, a 9-anthracenyl group and a pentafluorophenyl group; a C₁ to C₁₂ alkoxyphenyl group and a C₁ to C₁₂ alkylphenyl group are preferable. Specific examples of the C₁ to C₁₂ alkoxyphenyl group include a methoxyphenyl group, an ethoxyphenyl group, a n-propyloxyphenyl group, an isopropyloxyphenyl group, a n-butoxyphenyl group, an isobutoxyphenyl group, a s-butoxyphenyl group, a t-butoxyphenyl group, a n-pentyloxyphenyl group, a n-hexyloxyphenyl group, a cyclohexyloxyphenyl group, a n-heptyloxyphenyl group, a n-octyloxyphenyl group, a 2-ethylhexyloxyphenyl group, a n-nonyloxyphenyl group, a n-decyloxyphenyl group, a 3,7-dimethyloctyloxyphenyl group and a n-lauryloxyphenyl group. Specific examples of the C₁ to C₁₂ alkylphenyl group include a methylphenyl group, an ethylphenyl group, a dimethylphenyl group, a n-propylphenyl group, a mesityl group, a methylethylphenyl group, an isopropylphenyl group, a n-butylphenyl group, an isobutylphenyl group, a s-butylphenyl group, a t-butylphenyl group, a n-pentylphenyl group, an isoamylphenyl group, a hexylphenyl group, a n-heptylphenyl group, a n-octylphenyl group, a n-nonylphenyl group, a decylphenyl group and a n-dodecylphenyl group. The hydrogen atom or hydrogen atoms in the aryl groups may be substituted with a fluorine atom or fluorine atoms. 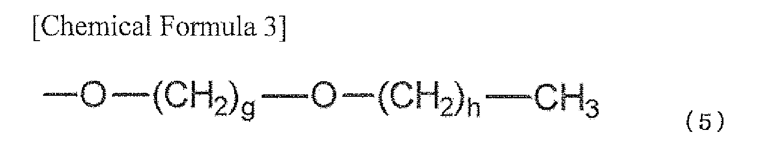 [In formula (5), g represents an integer of 1 to 6 and h an integer of 0 to 5.]

In formula (1), the definitions, the specific examples and others for the alkyl groups and the aryl groups represented by R³ and R⁴ are the same as the definitions, the specific examples and others as described above for R¹ and R².

Of the above-described low-molecular-weight aromatic compounds, the low-molecular-weight aromatic compounds each having a hydroxyphenyl group are preferable. Examples of the low-molecular-weight aromatic compound having a hydroxyphenyl group include the compounds respectively represented by the following formulas (2) and (2a) to (2f):

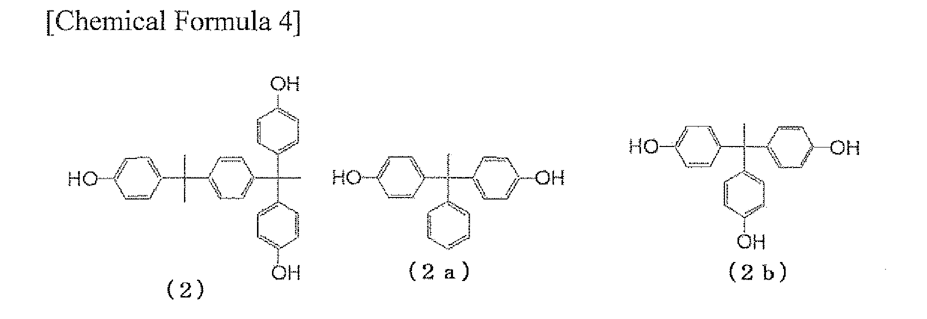

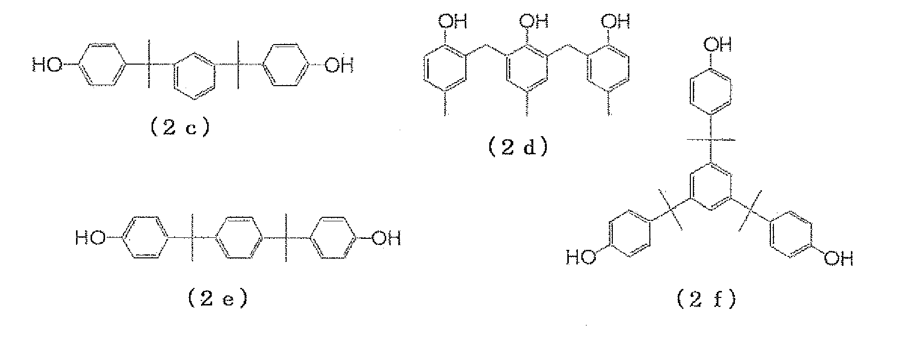

In formula (1), a carbon atom in R¹ and a carbon atom in R² may be bonded to each other to form a ring. Examples of the low-molecular-weight aromatic compound with such a ring formed therein include the compounds respectively represented by the following formulas (2g) to (2i). The concerned ring may be condensed with an aromatic hydrocarbon ring or a heterocyclic ring.

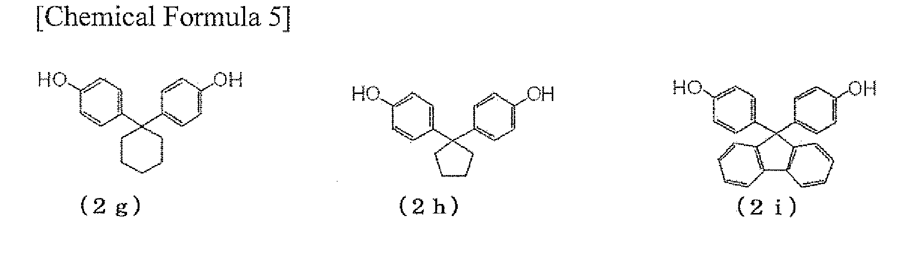

From the viewpoint of achieving a high photoelectric conversion efficiency, the low-molecular-weight aromatic compound is preferably a compound represented by the following formula (2):

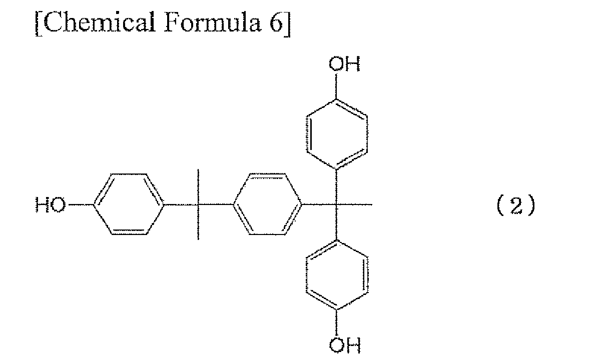

### <Estrogen>

Examples of the estrogen usable in the present invention include estron, estradiol and estriol. Among these, estradiol represented by the following formula (3) is preferable:

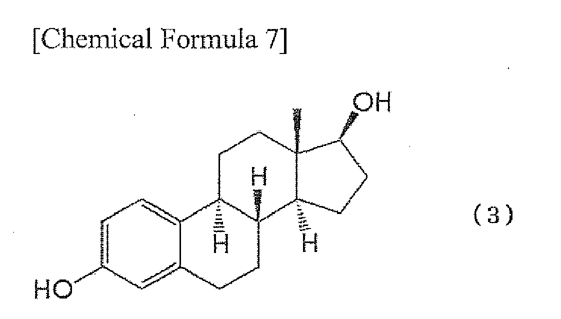

### <Nonconjugated Polymer Compound>

The nonconjugated polymer compound usable in the present invention has a hydroxyl group. The nonconjugated polymer compound preferably has a weight average molecular weight, relative to polystyrene standards, of 1×10³ to 1×10⁷.

Examples of the nonconjugated polymer compound include a polymer compound having the repeating unit represented by the following formula (4):

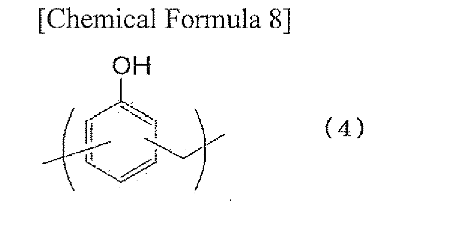

From the viewpoint of achieving a high photoelectric conversion efficiency, the organic photoelectric conversion element of the present invention preferably comprises an organic layer including the low-molecular-weight aromatic compound and the conjugated polymer compound.

### <Conjugated Polymer Compound>

The conjugated polymer compound used in the present invention means, for example, (i) a polymer substantially composed of a structure in which double bonds and single bonds are alternately arranged, (ii) a polymer substantially composed of a structure in which double bonds and single bonds are arranged through the intermediary of nitrogen atoms, and (iii) a polymer substantially composed of a structure in which double bonds and single bonds are alternately arranged and a structure in which double bonds and single bonds are arranged through the intermediary of nitrogen atoms. In the present description, the conjugated polymer compound specifically means a polymer in which one or two or more groups selected from the below defined group are used as the repeating units and the repeating units are bonded to each other directly or through the intermediary of linking groups: the group is defined as the group consisting of an unsubstituted or substituted fluorenediyl group, an unsubstituted or substituted benzofluorenediyl group, an unsubstituted or substituted dibenzofurandiyl group, an unsubstituted or substituted dibenzothiophenediyl group, an unsubstituted or substituted carbazolediyl group, an unsubstituted or substituted thiophenediyl group, an unsubstituted or substituted furandiyl group, an unsubstituted or substituted pyrrolediyl group, an unsubstituted or substituted benzothiazolediyl group, an unsubstituted or substituted phenylenevinylenediyl group, an unsubstituted or substituted thienylenevinylenediyl group and an unsubstituted or substituted triphenylaminediyl group.

In the conjugated polymer compound, when the repeating units are bonded to each other through the intermediary of linking groups, examples of the linking groups include phenylene, biphenylene, naphthalenediyl and anthracendiyl.

From the viewpoint of the charge transportability, the conjugated polymer compound used in the present invention preferably has one or more repeating units selected from the group consisting of the repeating units represented by the following formula (6) and the repeating units represented by the following formula (7): 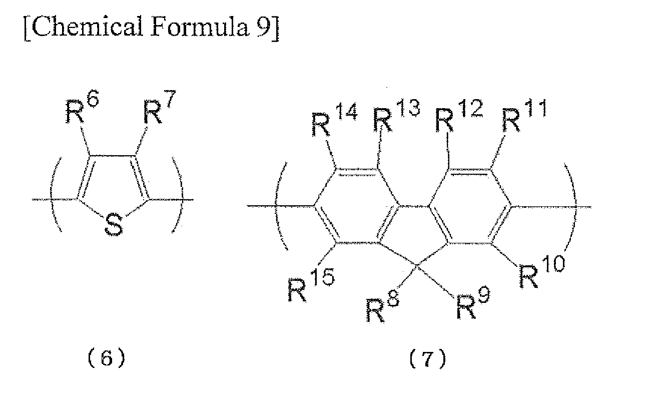 [in formula, R⁶, R⁷, R⁸, R⁹, R¹⁰, R¹¹, R¹², R¹³, R¹⁴ and R¹⁵ are the same as or different from each other, and each represent a hydrogen atom, an alkyl group, an alkoxy group, an alkylthio group, an aryl group, an aryloxy group, an arylthio group, an arylalkyl group, an arylalkoxy group or an arylalkylthio group.].

In formula (6) and formula (7), specific examples and others of the alkyl groups and the aryl groups represented by R⁶ to R¹⁵ are the same as the definitions, the specific examples and others as described above for R¹ and R².

In formula (6) and formula (7), each of the alkoxy groups represented by R⁶ to R¹⁵ may be linear or branched, or a cycloalkyloxy group. The number of carbon atoms in each of the alkoxy groups is usually about 1 to 20, and specific examples of the alkoxy groups include a methoxy group, an ethoxy group, a n-propyloxy group, an i-propyloxy group, a n-butoxy group, an i-butoxy group, a s-butoxy group, a t-butoxy group, a n-pentyloxy group, a n-hexyloxy group, a cyclohexyloxy group, a n-heptyloxy group, a n-octyloxy group, a 2-ethylhexyloxy group, a n-nonyloxy group, a n-decyloxy group, a 3,7-dimethyloctyloxy group and a n-lauryloxy group. The hydrogen atom or hydrogen atoms in the alkoxy groups may be substituted with a fluorine atom or fluorine atoms. Examples of the concerned substituents include a trifluoromethoxy group, a pentafluoroethoxy group, a perfluorobutoxy group, a perfluorohexyl group and a perfluorooctyl group.

In formula (6) and formula (7), each of the alkylthio groups represented by R⁶ to R¹⁵ may be linear or branched, or a cycloalkyltio group. The number of carbon atoms in each of the alkylthio groups is usually about 1 to 20, and specific examples of the alkylthio groups include a methylthio group, an ethylthio group, a n-propylthio group, an i-propylthio group, a n-butylthio group, an isobutylthio group, a s-butylthio group, a t-butylthio group, a n-pentylthio group, a n-hexylthio group, a cyclohexylthio group, a n-heptylthio group, a n-octylthio group, a 2-ethylhexylthio group, a n-nonylthio group, a n-decylthio group, 3,7-dimethyloctylthio group and a n-laurylthio group. The hydrogen atom or hydrogen atoms in the alkylthio groups may be substituted with a fluorine atom or fluorine atoms. Examples of the concerned substituents include a trifluoromethylthio group.

In formula (6) and formula (7), the number of carbon atoms in each of the aryloxy groups represented by R⁶ to R¹⁵ is usually about 6 to 60 and preferably 6 to 48. Specific examples of the aryloxy groups include a phenoxy group, a C₁ to C₁₂ alkoxyphenoxy group, a C₁ to C₁₂ alkylphenoxy group, a 1-naphthyloxy group, a 2-naphthyloxy group and a pentafluorophenyloxy group; a C₁ to C₁₂ alkoxyphenoxy group and a C₁ to C₁₂ alkylphenoxy group are preferable. Specific examples of the C₁ to C₁₂ alkoxy include methoxy, ethoxy, n-propyloxy, isopropyloxy, n-butoxy, isobutoxy, s-butoxy, t-butoxy, n-pentyloxy, n-hexyloxy, cyclohexyloxy, n-heptyloxy, n-octyloxy, 2-ethylhexyloxy, n-nonyloxy , n-decyloxy, 3,7-dimethyloctyloxy and n-lauryloxy. Specific examples of the C₁ to C₁₂ alkylphenoxy group include a methylphenoxy group, an ethyllphenoxy group, a dimethylphenoxy group, a n-propylphenoxy group, a 1,3,5-trimethylphenoxy group, a methylethylphenoxy group, an isopropylphenoxy group, a n-butylphenoxy group, an isobutylphenoxy group, a s-butylphenoxy group, a t-butylphenoxy group, a n-pentylphenoxy group, an isoamylphenoxy group, a n-hexylphenoxy group, a n-heptylphenoxy group, a n-octylphenoxy group, a n-nonylphenoxy group, a n-decylphenoxy group and a n-dodecylphenoxy group.

In formula (6) and formula (7), each of the arylthio groups represented by R⁶ to R¹⁵ may have a substituent or substituents in the aromatic ring thereof, and the number of carbon atoms in each of the arylthio groups is usually about 6 to 60. Specific examples of the arylthio groups include a phenylthio group, a C₁ to C₁₂ alkoxyphenylthio group, a C₁ to C₁₂ alkylphenylthio group, a 1-naphthylthio group, a 2-naphthylthio group, a pentafluoraphenylthio group, a pyridylthio group, a pyridazinylthio group, a pyrimidylthio group, a pyrazylthio group and a triazylthio group.

In formula (6) and formula (7), each of the arylalkyl groups represented by R⁶ to R¹⁵ may have a substituent or substituents, and the number of carbon atoms in each of the arylalkyl groups is usually about 7 to 60. Specific examples of the arylalkyl groups include a phenyl-C₁ to C₁₂ alkyl group, a C₁ to C₁₂ alkoxyphenyl-C₁ to C₁₂ alkyl group, a C₁ to C₁₂ alkylphenyl-C₁ to C₁₂ alkyl group, a 1-naphthyl-C₁ to C₁₂ alkyl group and a 2-naphthyl-C₁ to C₁₂ alkyl group.

In formula (6) and formula (7), each of the arylalkoxy groups represented by R⁶ to R¹⁵ may have a substituent or substituents, and the number of carbon atoms in each of the arylalkoxy groups is usually about 7 to 60. Specific examples of the arylalkoxy groups include a phenyl-C₁ to C₁₂ alkoxy group, a C₁ to C₁₂ alkoxyphenyl-C₁ to C₁₂ alkoxy group, a C₁ to C₁₂ alkylphenyl-C₁ to C₁₂ alkoxy group, a 1-naphthyl-C₁ to C₁₂ alkoxy group and a 2-naphthyl-C₁ to C₁₂ alkoxy group.

In formula (6) and formula (7), each of the arylalkylthio groups represented by R⁶ to R¹⁵ may have a substituent or substituents, and the number of carbon atoms in each of the arylalkylthio groups is usually about 7 to 60. Specific examples of the arylalkythio groups include a phenyl-C₁ to C₁₂ alkylthio group, a C₁ to C₁₂ alkoxyphenyl-C₁ to C₁₂ alkylthio group, a C₁ to C₁₂ alkylphenyl-C₁ to C₁₂ alkylthio group, a 1-naphthyl-C₁ to C₁₂ alkylthio group and a 2-naphthyl-C₁ to C₁₂ alkylthio group.

From the viewpoint of the film forming ability and the solubility to the solvent, the conjugated polymer compound has a weight average molecular weight relative to polystyrene standards of preferably 1×10³ to 1×10⁷ and more preferably 1×10³ to 1×10⁶.

The conjugated polymer compound included in the organic layer belonging to the organic photoelectric conversion element of the present invention may be of one type or of two or more types.

It is possible to synthesize the conjugated polymer by polymerization as follows: a monomer having a functional group appropriate to the adopted polymerization reaction is synthesized, then dissolved where necessary in an organic solvent, and the monomer is polymerized by a heretofore known polymerization method such as aryl coupling using an alkali, an appropriate catalyst and a ligand.

### <Organic Layer>

In the organic layer belonging to the organic photoelectric conversion element of the present invention, one or more compounds selected from the group consisting of the low-molecular-weight aromatic compound, estrogen and the nonconjugated polymer compound having a hydroxyl group, and the conjugated polymer compound are included. The content of the one or more compounds selected from the group consisting of the low-molecular-weight aromatic compound, estrogen and the nonconjugated polymer compound having a hydroxyl group is preferably 0.1 to 10000 parts by weight, more preferably 1 to 1000 parts by weight and furthermore preferably 5 to 500 parts by weight in relation to 100 parts by weight of the conjugated polymer compound.

In the organic layer belonging to the organic photoelectric conversion element of the present invention, an electron-accepting compound may further be included. Examples of the electron-accepting compound include oxadiazole derivatives, anthraquinodimethane and derivatives thereof, benzoquinone and derivatives thereof, naphthoquinone and derivatives thereof, anthraquinone and the derivative thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorenone and the derivative thereof, C₆₀ and other flullerenes and the derivative thereof, carbon nanotube and phenanthroline derivatives such as 2,9-dimethyl-4,7-diphenyl-1,10-phenanthroline. From the viewpoint of achieving a high photoelectric conversion efficiency, fullerenes and derivatives thereof are preferable as the electron-accepting compound.

When the electron-accepting compound is included, the content of the electron-accepting compound in the organic layer is preferably 1 to 10000 parts by weight, more preferably 10 to 2000 parts by weight, furthermore preferably 10 to 1000 parts by weight and particularly preferably 50 to 500 parts by weight, in relation to 100 parts by weight of the total of the content of one or more compounds selected from the group consisting of the low-molecular-weight aromatic compound, estrogen and the nonconjugated polymer compound having a hydroxyl group and the content of the conjugated polymer compound.

Examples of the fullerenes include C₆₀, C₇₀, C₈₄ and derivatives thereof. Examples of the specific structures of the derivatives of C₆₀ fullerene include the compounds represented by the following formulas (8a) to (8g):

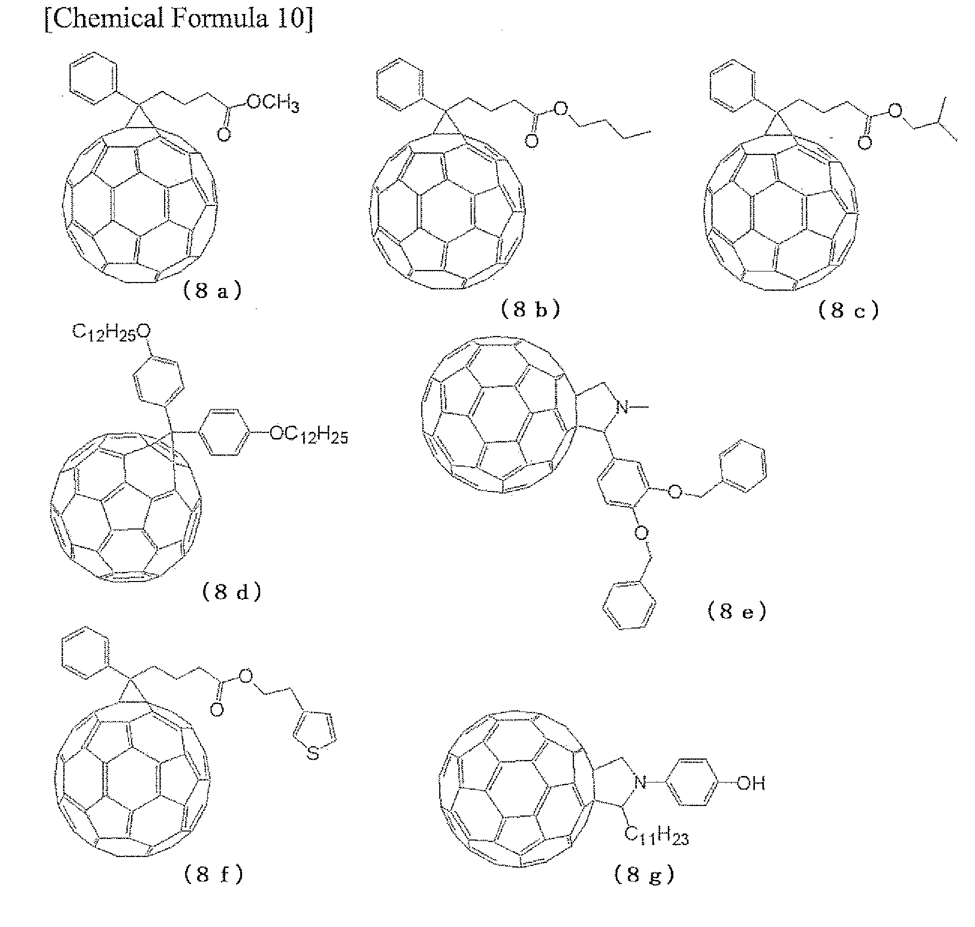

In the organic layer belonging to the organic photoelectric conversion element of the present invention, an electron-donating compound may further be included. Examples of the electron-donating compound include pyrazoline derivatives, arylamine derivatives, stilbene derivatives, triphenyldiamine derivatives, oligothiophene and derivatives thereof, polyvinylcarbazole and derivatives thereof, polysilane and derivatives thereof, polysiloxane derivatives having an aromatic amine in the side chain or the main chain, polyaniline and derivatives thereof, polythiophene and derivatives thereof, polypyrrole and derivatives thereof, polyphenylenevinylene and derivatives thereof and polythienylenevinylene and derivatives thereof.

When the electron-donating compound is included, the content of the electron-donating compound in the organic layer is preferably 1 to 100000 parts by weight, more preferably 10 to 1000 parts by weight and furthermore preferably 50 to 500 parts by weight, in relation to 100 parts by weight of the total of the content of one or more compounds selected from the group consisting of the low-molecular-weight aromatic compound, estrogen and the nonconjugated polymer compound having a hydroxyl group and the content of the conjugated polymer compound.

In the organic layer belonging to the organic photoelectric conversion element of the present invention, within the range not impairing the charge transportability and the charge injectability, there may be included components other than the low-molecular-weight aromatic compound, estrogen, the nonconjugated polymer compound, the conjugated polymer compound, the electron-donating compound and the electron-accepting compound.

### <Organic Photoelectric Conversion Element>

The organic photoelectric conversion element of the present invention comprises a pair of electrodes, at least one of the electrodes being transparent or translucent, and an organic layer disposed between the pair of electrodes, wherein the organic layer comprises one or more compounds selected from the group consisting of the low-molecular-weight aromatic compound, estrogen and the nonconjugated polymer compound having a hydroxyl group and includes the conjugated polymer compound. The one or more compounds selected from the group consisting of the low-molecular-weight aromatic compound, estrogen and the nonconjugated polymer compound having a hydroxyl group, and the conjugated polymer compound are all usable either as electron-accepting compounds or as electron-donating compounds. Furthermore, for the one or more compounds selected from the group consisting of the low-molecular-weight aromatic compound, estrogen and the nonconjugated polymer compound having a hydroxyl group, and the conjugated polymer compound, where one of the compound is an electron-donating compound and the other is an electron-accepting compound, the composition may have both the functions of the electron donor and the electron acceptor. Among these aspects, preferable is the aspect in which the one or more compounds selected from the group consisting of the low-molecular-weight aromatic compound, estrogen and the nonconjugated polymer compound having a hydroxyl group, and the conjugated polymer compound are all used as electron-donating compounds.

Next, the operation mechanism of the organic photoelectric conversion element is described. Photoenergy incident from the transparent or translucent electrode is absorbed by the electron-accepting compound and/or the electron-donating compound to generate excitons each composed of an electron and a hole bound to each other. When the generated excitons move and reach the heterojunction interface where the electron-accepting compound and the electron-donating compound are adjacent to each other, electrons and holes separate, due to the difference between the HOMO energy and the LUMO energy in each of these compounds at the interface, to generate charges (electrons and holes) that can move independently. The generated charges move to the electrodes respectively, and hence the charges can be taken out as electrical energy (current) to the outside.

Specific examples of the organic photoelectric conversion element of the present invention include the following.
1. An organic photoelectric conversion element comprising: a pair of electrodes; a first organic layer, provided between the electrodes, including one or more compounds selected from the group consisting of the low-molecular-weight aromatic compound, estrogen and the nonconjugated polymer compound having a hydroxyl group and the conjugated polymer compound; and a second organic layer, disposed so as to be adjacent to the first organic layer including an electron-donating compound.
2. An organic photoelectric conversion element comprising: a pair of electrodes; a first organic layer, provided between the electrodes, including an electron-accepting compound; a second organic layer, disposed so as to be adjacent to the first organic layer, including one or more compounds selected from the group consisting of the low-molecular-weight aromatic compound, estrogen and the nonconjugated polymer compound having a hydroxyl group and the conjugated polymer compound.
3. An organic photoelectric conversion element comprising: a pair of electrodes; and at least one organic layer, provided between the electrodes, including one or more compounds selected from the group consisting of the low-molecular-weight aromatic compound, estrogen and the nonconjugated polymer compound having a hydroxyl group, the conjugated polymer compound and an electron-donating compound.
4. An organic photoelectric conversion element comprising: a pair of electrodes; an organic layer, provided between the electrodes, including one or more compounds selected from the group consisting of the low-molecular-weight aromatic compound, estrogen and the nonconjugated polymer compound having a hydroxyl group, the conjugated polymer compound and an electron-accepting compound.
5. An organic photoelectric conversion element comprising a pair of electrodes; at least one organic layer, provided between the electrodes, including one or more compounds selected from the group consisting of the low-molecular-weight aromatic compound, estrogen and the nonconjugated polymer compound having a hydroxyl group, the conjugated polymer compound and an electron-accepting compound; wherein the electron-accepting compound is a fullerene derivative.

Additionally, in the organic photoelectric conversion element of the above 5., the content of the fullerene derivative in the organic layer is preferably 10 to 1000 parts by weight and more preferably 50 to 500 parts by weight in relation to 100 parts by weight of the total of the content of the one or more compounds selected from the group consisting of the low-molecular-weight aromatic compound, estrogen and the nonconjugated polymer compound having a hydroxyl group and the content of the conjugated polymer compound.

From such viewpoints, as the organic photoelectric conversion element of the present invention, the above 3. the above 4. or the above 5. is preferable, and the above 5. is more preferable from the viewpoint that the above 5. includes many heterojunction interfaces. Additionally, in the organic photoelectric conversion element of the present invention, an additional layer may be disposed at at least between one of the electrodes and the organic layer in the element. Examples of the additional layer include a charge transporting layer for transporting holes or electrons.

When a composition composed of the one or more compounds selected from the group consisting of the low-molecular-weight aromatic compound, estrogen and the nonconjugated polymer compound having a hydroxyl group, and the conjugated polymer compound is used as an electron donor, the electron acceptor preferably used in the organic photoelectric conversion element is such that the HOMO energy of the electron acceptor is higher than any HOMO energy of the HOMO energy of the conjugated polymer compound, the HOMO energy of the low-molecular-weight aromatic compound, the HOMO energy of the estrogen and the HOMO energy of the nonconjugated polymer compound, and the LUMO energy of the electron acceptor is higher than any LUMO energy of the LUMO energy of the conjugated polymer compound, the LUMO energy of the low-molecular-weight aromatic compound, the LUMO energy of the estrogen and the LUMO energy of the nonconjugated polymer compound. Additionally, when the composition composed of the one or more compounds selected from the group consisting of the low-molecular-weight aromatic compound having a group derived by removing two hydrogen atoms from the structure represented by formula (1) and a hydroxyl group, estrogen and the nonconjugated polymer compound having a hydroxyl group, and a conjugated polymer compound is used as an electron acceptor, the electron donor preferably used in the organic photoelectric conversion element is such that the HOMO energy of the electron donor is lower than any HOMO energy of the HOMO energy of the conjugated polymer compound, the HOMO energy of the low-molecular-weight aromatic compound, the HOMO energy of the estrogen and the HOMO energy of the nonconjugated polymer compound, and the LUMO energy of the electron donor is lower than any LUMO energy of the LUMO energy of the conjugated polymer compound, the LUMO energy of the low-molecular-weight aromatic compound, the LUMO energy of the estrogen and the LUMO energy of the nonconjugated polymer compound.

The organic photoelectric conversion element of the present invention is usually formed on a substrate. The substrate has only to be a substrate that does not undergo any change when electrodes are formed and a layer of an organic substance is formed. Examples of the material of the substrate include glass, plastic, polymer film, and silicon. In the case of an opaque substrate, the opposite electrode (that is, the electrode far from the substrate) is preferably transparent or translucent.

Examples of the material of the transparent or translucent electrode include a conductive metal oxide film and a translucent metal thin film. Specifically, used are the films (such as NESA) prepared by using conductive materials composed of, for example, indium oxide, zinc oxide, tin oxide, and indium tin oxide (ITO) and indium zinc oxide, which are composite materials of these; also used are gold, platinum, silver, copper and the like; preferable ITO, indium zinc oxide, tin oxide and the like. Examples of the method for preparing the electrode include a vacuum deposition method, a sputtering method, an ion plating method, and a plating method. As the electrode materials, organic transparent conductive films of, for example, polyaniline and derivatives thereof, and polythiophene and derivatives thereof may also be used. Further, it is possible to use metals, conductive polymers and the like as the electrode materials, and one electrode of the pair of electrodes is preferably of a material having a small work function. The materials used as such electrode materials are, for example, as follows: metals such as lithium, sodium, potassium, rubidium, cesium, magnesium, calcium, strontium, barium, aluminum, scandium, vanadium, zinc, yttrium, indium, cerium, samarium, europium, terbium and ytterbium; alloys of two or more of these metals; alloys of one or more of these metals and one or more of gold, silver, platinum, copper, manganese, titanium, cobalt, nickel, tungsten and tin; graphite; or graphite intercalation compounds.

Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

As the material used for the charge transporting layer as an additional layer, namely, the hole transporting layer or the electron transporting layer, it is possible to use the below-described electron-donating compound or the electron-accepting compound, respectively. As the material used as a buffer layer as an additional layer, it is possible to use halides and oxides of alkali metals and alkali earth metals such as lithium fluoride. It is also possible to use fine particles of an inorganic semiconductor such as titanium oxide.

As the organic layer in the organic photoelectric conversion element of the present invention, there can be used, for example, an organic thin film comprising the one or more compounds selected from the group consisting of the low-molecular-weight aromatic compound, estrogen and the nonconjugated polymer compound having a hydroxyl group, and the conjugated polymer compound.

The thickness of the organic thin film is usually 1 nm to 100 µm, preferably 2 nm to 1000 nm, more preferably 5 nm to 500 nm and furthermore preferably 20 nm to 200 nm.

For the purpose of enhancing the hole transportability of the organic thin film, it is also possible to use components other than the low-molecular-weight aromatic compound, estrogen, the nonconjugated polymer compound and the conjugated polymer compound, by mixing in the organic thin film as the electron-donating compound and/or the electron-accepting compound.

### <Method for Producing Organic Thin Film>

The organic layer included in the organic photoelectric conversion element of the present invention can be produced by using a composition composed of the one or more compounds selected from the group consisting of the low-molecular-weight aromatic compound, estrogen and the nonconjugated polymer compound having a hydroxyl group, and the conjugated polymer compound. When an electron-accepting compound is further included in the organic layer, the organic layer can be produced by using a composition composed of the one or more compounds selected from the group consisting of the low-molecular-weight aromatic compound, estrogen and the nonconjugated polymer compound having a hydroxyl group, and the conjugated polymer compound and the electron-accepting compound. Additionally, when an electron-donating compound is further included in the organic layer, the organic layer can be produced by using a composition composed of the one or more compounds selected from the group consisting of the low-molecular-weight aromatic compound, estrogen and the nonconjugated polymer compound having a hydroxyl group, and the conjugated polymer compound and the electron-donating compound.

The content of the one or more compounds selected from the group consisting of the low-molecular-weight aromatic compound, estrogen and the nonconjugated polymer compound having a hydroxyl group in the composition is preferably 0.1 to 10000 parts by weight and more preferably 1 to 1000 parts by weight, in relation to 100 parts by weight of the conjugated polymer compound. When an electron-accepting compound is included in the composition, the content of the electron-accepting compound in the composition is preferably 1 to 10000 parts by weight and more preferably 10 to 2000 parts by weight, in relation to 100 parts by weight of the total of the content of the one or more compounds selected from the group consisting of the low-molecular-weight aromatic compound, estrogen and the nonconjugated polymer compound having a hydroxyl group and the content of the conjugated polymer compound. When an electron-donating compound is included in the composition, the content of the electron-donating compound in the composition is preferably 1 to 100000 parts by weight and more preferably 10 to 1000 parts by weight, in relation to 100 parts by weight of the total of the content of the one or more compounds selected from the group consisting of the low-molecular-weight aromatic compound, estrogen and the nonconjugated polymer compound having a hydroxyl group and the content of the conjugated polymer compound.

The method for producing the organic thin film is not particularly limited, and examples of such a method include a method for forming a film from a solution containing the composition and a solvent; a thin film may also be formed by a vacuum vapor deposition method.

The solvent used for the film formation from a solution is not particularly limited as long as the solvent dissolves the one or more compounds selected from the group consisting of the low-molecular-weight aromatic compound, estrogen and the nonconjugated polymer compound having a hydroxyl group and the conjugated polymer compound. Examples of such a solvent include: unsaturated hydrocarbon solvents such as toluene, xylene, mesitylene, tetralin, decalin, bicyclohexyl, n-butylbenzene, sec-butylbenzene and t-butylbenzene; halogenated saturated hydrocarbon solvents such as carbon tetrachloride, chloroform, dichloromethane, dichloroethane, chlorobutane, bromobutane, chlorosulfurpentane, bromopentane, chlorohexane, bromohexane, chlorocyclohexane and bromocyclohexane; halogenated unsaturated hydrocarbon solvents such as chlorobenzene, dichlorobenzene and trichlorobenzene; and ether solvents such as tetrahydrofuran and tetrahydropyran. The composition, used in the present invention, composed of the one or more compounds selected from the group consisting of the low-molecular-weight aromatic compound having a group derived by removing two hydrogen atoms from the structure represented by formula (1) and a hydroxyl group, estrogen and the nonconjugated polymer compound having a hydroxyl group, and the conjugated polymer compound can usually be dissolved in the solvent in a content of 0.1 % by weight or more.

For the film formation from a solution, it is possible to use the coating methods such as spin coating, casting, microgravure coating, gravure coating, bar coating, roll coating, wire bar coating, dip coating, spray coating, screen printing, flexographic printing, offset printing, ink jet printing, dispenser printing, nozzle coating and capillary coating; and spin coating, flexographic printing, ink jet printing and dispenser printing are preferable.

### <Uses of Element>

The organic photoelectric conversion element generates photovoltaic power between the electrodes by the irradiation from the transparent or translucent electrode with light such as sunlight, and thus can be made to operate as an organic thin film solar cell. By integrating a plurality of organic thin film solar cells, such a plurality of organic thin film solar cells can also be used as an organic thin film solar cell module.

Under the condition that a voltage is applied between the electrodes, by the irradiation from the transparent or translucent electrode with light, photocurrent flows, and thus the organic photoelectric conversion element can also be made to operate as an organic optical sensor. By integrating a plurality of organic optical sensors, such a plurality of organic optical sensors can also be used as an organic image sensor.

### Examples

Hereinafter, Examples are presented for the purpose of describing the present invention in further detail, but the present invention is not limited to these Examples.

### (Measurement Method of Molecular Weight)

In following Examples, the molecular weight of the conjugated polymer compound was measured by the GPC (PL-GPC2000) manufactured by GPC Laboratory. The conjugated polymer compound was dissolved in o-dichlorobenzene so as for the concentration to be about 1% by weight. As a mobile phase for GPC, o-dichlorobenzene was used, and this was allowed to flow at a flow rate of 1 mL/min at a measurement temperature of 140°C. As the column, three PLGEL 10 µm MIXED-B columns (manufactured by PL Laboratories, Inc.) connected in series were used.

### Synthesis Example 1

### (Synthesis of Conjugated Polymer Compound 1)

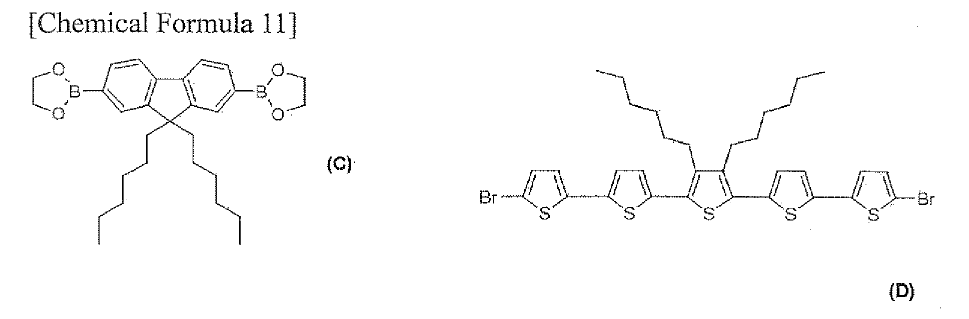

In a 2-L four neck flask with air replaced by argon, the compound (C) (7.928 g, 16.72 mmol), the compound (D) (13.00 g, 17.60 mmol), methyltrioctylammonium chloride (4.979 g) (trade name: "Aliquat 336" (trade mark), manufactured by Aldrich, Inc., CH₃N[(CH₂)₇CH₃]₃Cl, density: 0.884 g/mL., 25°C) and 405 mL of toluene were placed, and then the reaction system was bubbled with argon gas under stirring for 30 minutes. Dichlorobis(triphenylphosphine)palladium (II) (0.02 g) was added to the reaction mixture, the reaction mixture was heated to 105°C, and 42.2 ml of a 2 mol/L aqueous solution of sodium carbonate was added dropwise to the reaction mixture under stirring. The reaction was allowed to proceed for 5 hours from the completion of the dropwise addition, then phenyl boronic acid (2.6 g) and 1.8 mL of toluene were added to the reaction mixture, and the reaction mixture was stirred at 105°C for 16 hours. To the reaction mixture, 700 mL of toluene and 200 mL of a 7.5% aqueous solution of sodium diethyldithiocarbamate trihydrate were added and stirred at 85°C for 3 hours. The aqueous layer was removed, and the remaining layer was washed with 300 mL ion-exchanged water at 60°C two times, with 300 mL of 3% acetic acid at 60°C once, and further with 300 mL of ion-exchanged water at 60°C three times. Then, the organic layer was made to pass through a column packed with celite, alumina and silica, and the column was washed with 800 mL of hot toluene. The resulting solution was concentrated to 700 mL, and then poured into 2 L of methanol to perform reprecipitation. The resulting polymer was collected by filtration, and washed with 500 mL of methanol, acetone and methanol. The washed polymer was dried at 50°C overnight under vacuum, and thus 12.21 g of a pentathienyl-fluorenone copolymer (hereinafter, referred to as the "conjugated polymer compound 1") represented by the following formula (10) was obtained. The number average molecular weight and the weight average molecular weight, relative to polystyrene standards, of the conjugated polymer compound 1 were found to be 5.4×10⁴ and 1.1×10⁵, respectively.

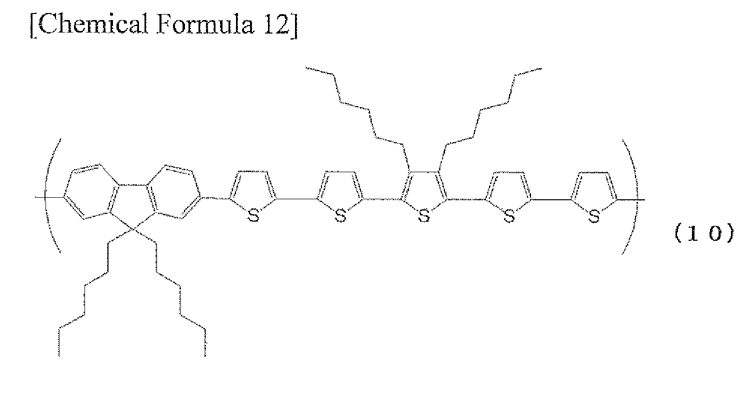

### Example 1

### (Preparation and Evaluation of Organic Thin Film Solar Cell)

The "conjugated polymer compound 1" was dissolved in o-dichlorobenzene in a concentration of 0.5% by weight. Then, 20 parts by weight of the compound (E) (trade name "Trisphenol PA," manufactured by Honshu Chemical Industry Co., Ltd.), which is the low-molecular-weight aromatic compound, in relation to 100 parts by weight of the "conjugated polymer compound 1," and further, 300 parts by weight of C60 PCBM (Phenyl C61-butyric acid methyl ester, trade name: "E100," Lot No.:8A0125A, manufactured by Frontier Carbon Corp.) as an electron acceptor in relation to 100 parts by weight of the "conjugated polymer compound 1" were mixed in the solution. Then, the solution was filtered with a Teflon (trade mark) filter of 1.0 µm in pore size, and thus a coating solution was prepared.

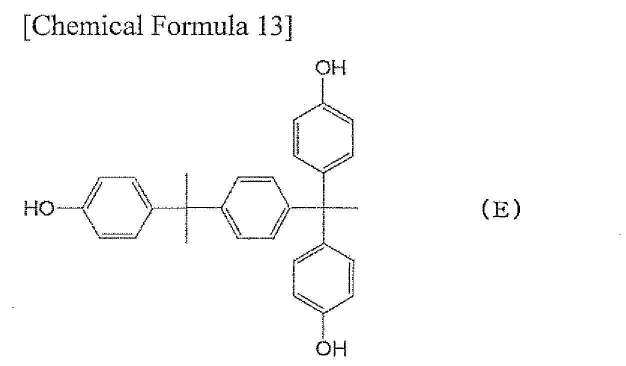

A glass substrate on which an ITO film with a thickness of 150 nm was provided by sputtering was subjected to ozone-UV treatment to perform surface treatment. Next, the ITO film was coated with the coating solution by spin coating, and thus the active layer (film thickness: about 100 nm) of an organic thin film solar cell was obtained. Then, on the active layer, by using a vacuum vapor deposition apparatus, lithium fluoride was vapor-deposited in a thickness of 4 nm, and then Al was vapor-deposited in a thickness of 100 nm. The degree of vacuum at the time of vapor deposition was always 1 to 9×10⁻³ Pa. The shape of the obtained organic thin film solar cell was a 2 mm × 2 mm square. The photoelectric conversion efficiency of the obtained organic thin film solar cell was obtained by measuring the current and voltage generated by irradiating the organic thin film solar cell with a predetermined amount of light by using a solar simulator (trade name: "OTENTO-SUN II": AM 1.5G filter, irradiance: 100 mW/cm², manufactured by Bunkoukeiki Co., LTD.). The result thus obtained is shown in Table 1.

### Example 2

### (Preparation and Evaluation of Organic Thin Film Solar Cell)

The "conjugated polymer compound 1" was dissolved in o-dichlorobenzene in a concentration of 0.5% by weight. Then, 20 parts by weight of the compound (E), which is the low-molecular-weight aromatic compound, in relation to 100 parts by weight of the "conjugated polymer compound 1," and further, 500 parts by weight of C70 PCBM (Phenyl C71-butyric acid methyl ester, trade name: "ADS71BFA," Lot No.:08C059E, manufactured by American Dye Source, Inc.) as an electron acceptor in relation to 100 parts by weight of the "conjugated polymer compound 1" were mixed in the solution. Then, the solution was filtered with a Teflon (trade mark) filter of 1.0 µm in pore size, and thus a coating solution was prepared. By using the coating solution, an organic thin film solar cell was prepared in the same manner as in Example 1, and the photoelectric conversion efficiency of the organic thin film solar cell was measured. The measurement result is shown in Table 1.

### Example 3

### (Preparation and Evaluation of Organic Thin Film Solar Cell)

The "conjugated polymer compound 1" was dissolved in o-dichlorobenzene in a concentration of 0.5% by weight. Then, 50 parts by weight of the compound (F) (estradiol) (manufactured by Sigma-Aldrich, Inc.) as estrogen in relation to 100 parts by weight of the "conjugated polymer compound 1," and further, 300 parts by weight of C60 PCBM (Phenyl C61-butyric acid methyl ester, trade name: "E100," Lot No.:8A0125-A, manufactured by Frontier Carbon Corp.) as an electron acceptor in relation to 100 parts by weight of the "conjugated polymer compound 1" were mixed in the solution. Then, the solution was filtered with a Teflon (trade mark) filter of 1.0 µm in pore size, and thus a coating solution was prepared. By using the coating solution, an organic thin film solar cell was prepared in the same manner as in Example 1, and the photoelectric conversion efficiency of the organic thin film solar cell was measured. The measurement result is shown in Table 1.

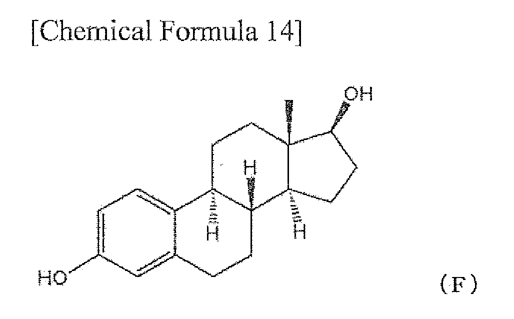

### Example 4

### (Preparation and Evaluation of Organic Thin Film Solar Cell)

The "conjugated polymer compound 1" was dissolved in o-dichlorobenzene in a concentration of 0.5% by weight. Then, 50 parts by weight of the compound (G) (1,1,1-tris(4-hydroxyphenyl)ethane, manufactured by Tokyo Chemical Industry Co., Ltd.), which is the low-molecular-weight aromatic compound, in relation to 100 parts by weight of the "conjugated polymer compound 1," and further, 300 parts by weight of C60 PCBM (Phenyl C61-butyric acid methyl ester, trade name: "E100," Lot No.:8A0125-A, manufactured by Frontier Carbon Corp.) as an electron acceptor in relation to 100 parts by weight of the "conjugated polymer compound 1" were mixed in the solution. Then, the solution was filtered with a Teflon (trade mark) filter of 1.0 µm in pore size, and thus a coating solution was prepared. By using the coating solution, an organic thin film solar cell was prepared in the same manner as in Example 1, and the photoelectric conversion efficiency of the organic thin film solar cell was measured. The measurement result is shown in Table 1.

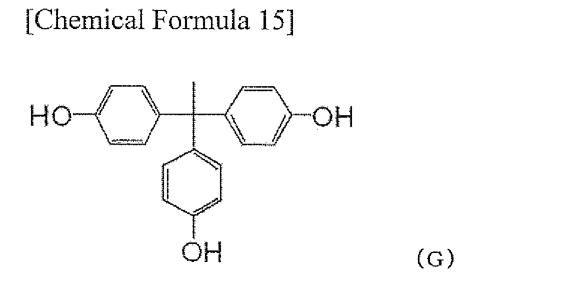

### Comparative Example 1

### (Preparation and Evaluation of Organic Thin Film Solar Cell)

An organic thin film solar cell was prepared in the same manner as in Example 1 except that the compound (E) was not used, and the photoelectric conversion efficiency of the organic thin film solar cell was measured. The measurement result is shown in Table 1.

### Comparative Example 2

### (Preparation and Evaluation of Organic Thin Film Solar Cell)

An organic thin film solar cell was prepared in the same manner as in Example 2 except that the compound (E) was not used, and the photoelectric conversion efficiency of the organic thin film solar cell was measured. The measurement result is shown in Table 1.

**[Table 1]**

| | Low-molecular-weight aromatic compound having a group derived by removing two hydrogen atoms from the structure represented by formula (1) and a hydroxyl group, or Estrogen | Fullferene derivative | Photoelectric conversion efficiency (%) |
|---|---|---|---|
| Example 1 | Compound (E) | C60PCBM | 3.3 |
| Example 2 | Compound (E) | C70PCBM | 4.8 |
| Example 3 | Compound (F) | C60PCBM | 3.0 |
| Example 4 | Compound (G) | C60PCBM | 3.1 |
| Comparative Example 1 | None | C60PCBM | 2.8 |
| Comparative Example 2 | None | C70PCBM | 3.8 |

### [Evaluation]

As seen from Table 1, the organic photoelectric conversion elements each comprising an organic layer including one or more compounds selected from the group consisting of a conjugated polymer compound, a low-molecular-weight aromatic compound having a group derived by removing two hydrogen atoms from the structure represented by formula (1) and a hydroxyl group, estrogen and a nonconjugated polymer compound having a hydroxl group, and a conjugated polymer compound each exhibited a higher photoelectric conversion efficiency as compared to the organic photoelectric conversion elements each having an organic layer including only a conjugated polymer compound.

## Claims

1. An organic photoelectric conversion element comprising a pair of electrodes, at least one of the electrodes being transparent or translucent, and an organic layer disposed between the pair of electrodes,
wherein the organic layer comprises a conjugated polymer compound, and one or more compounds selected from the group consisting of a low-molecular-weight aromatic compound having a group derived by removing two hydrogen atoms from the structure represented by the following formula (1) and a hydroxyl group, estrogen and a nonconjugated polymer compound having a hydroxyl group: 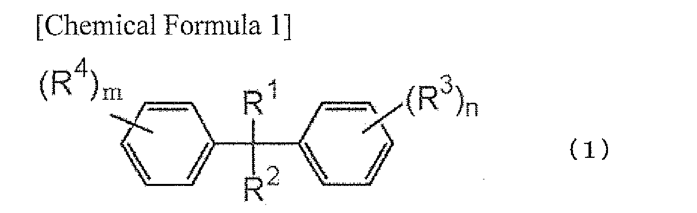 [in formula (1), R¹ and R² are the same as or different from each other, and each represent a hydrogen atom, an alkyl group or an aryl group, and a carbon atom in R¹ and a carbon atom in R² may be bonded to each other to form a ring; R³ and R⁴ are the same as or different from each other, and each represent an alkyl group or an aryl group; m and n are the same as or different from each other, and each represent an integer of 0 to 4; when there are a plurality of R³s, the R³s may be the same as or different from each other; and when there are a plurality of R⁴s, the R⁴s may be the same as or different from each other.].

2. The organic photoelectric conversion element according to claim 1, wherein the low-molecular-weight aromatic compound is a compound having a hydroxyphenyl group.

3. The organic photoelectric conversion element according to claim 1, wherein the low-molecular-weight aromatic compound is the compound represented by the following formula (2).

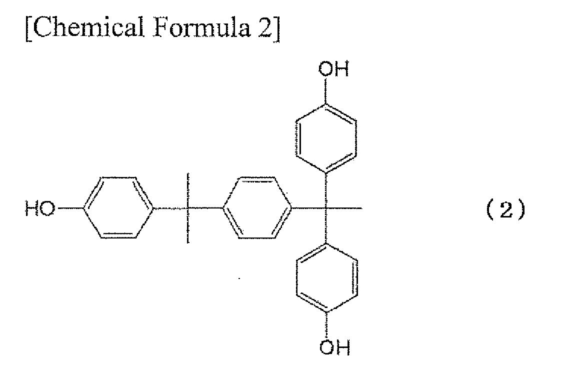

4. The organic photoelectric conversion element according to claim 1, wherein the content of the one or more compounds selected from the group consisting of the low-molecular-weight aromatic compound, estrogen and the nonconjugated polymer compound having a hydroxyl group is 0.1 to 10000 parts by weight in relation to 100 parts by weight of the conjugated polymer compound.

5. The organic photoelectric conversion element according to any one of claims 1 to 4, wherein the organic layer further comprises an electron-accepting compound.

6. The organic photoelectric conversion element according to claim 5, wherein the electron-accepting compound is a fullerene derivative.

7. The organic photoelectric conversion element according to any one of claims 1 to 4, wherein the organic layer further comprises an electron-donating compound.
